# EUROPEAN PATENT SPECIFICATION

(11) **EP 3 316 386 B1**
(45) Date of publication and mention of the grant of the patent: **21.08.2019**
(21) Application number: 16195848.3
(22) Date of filing: 26.10.2016
(51) Int. Cl.: H01M 10/42, H01M 10/48, H01M 2/10, H01M 2/20, H01M 2/30

(54) **CONNECTOR PART FOR A PRINTED CIRCUIT BOARD AND A BATTERY SYSTEM COMPRISING THE PRINTED CIRCUIT BOARD AND THE CONNECTOR PART**
STECKERTEIL FÜR EINE LEITERPLATTE UND BATTERIESYSTEM MIT DER LEITERPLATTE UND DEM STECKERTEIL
PARTIE CONNECTEUR DE CARTE DE CIRCUIT IMPRIMÉ ET SYSTÈME DE BATTERIE COMPRENANT LA CARTE DE CIRCUIT IMPRIMÉ ET LA PARTIE CONNECTEUR

(43) Date of publication of application: 02.05.2018
(73) Proprietor: Samsung SDI Co., Ltd., Giheung-gu Yongin-si, Gyeonggi-do 17084 (KR)
(72) Inventor: Hammerschmied, Helmut, 8020 Graz (AT); Hofer, Maximilian, 8230 Hartberg (AT); Apolloner, Peter, 8010 Graz (AT)
(74) Representative: Gulde & Partner

(56) References cited:
- EP-A1- 2 421 067
- CN-U- 203 812 935
- US-A1- 2013 101 883

## Description

### Field of the Invention

The present invention relates to a connector for a printed circuit board (PCB) for connecting the PCB to other (external) electrical components, a battery system comprising the printed circuit board and the connector part, and a vehicle including the battery system.

### Technological Background

Rechargeable or secondary batteries that can be repeatedly charged and discharged are widely used in many different devices. While low-capacity rechargeable batteries are generally used as power supply for small electronic devices, such as cellular phones, notebook computers and camcorders, high-capacity rechargeable batteries are mostly used as power supply for hybrid vehicles and the like.

In general, rechargeable battery cells include an electrode assembly including a positive electrode, a negative electrode, and a separator interposed between the positive and negative electrodes, a case accommodating the electrode assembly, and electrode terminals electrically connected to the electrode assembly. The shape of the case, e.g. cylindrical or rectangular, may be varied according to the intended purpose and design of the device.

Battery modules comprising a plurality of unit battery cells coupled in series and/or in parallel are used to provide the required energy density. The battery module is formed by interconnecting the electrode terminals of the plurality of unit battery cells, wherein the number of unit cells depends on the required amount of power.

Battery modules can be constructed either in a block design or in a modular design. In a block designs each battery cell is coupled to a common current collector structure and a common battery management system. In modular designs, a plurality of battery cells connected to each other forms a submodule and several submodules are connected to each other to form the module. A plurality of battery modules can be combined in order to realize a high-power rechargeable battery, e.g. for an electric or hybrid vehicle. Therein, one or more battery modules are mechanically and electrically integrated and set up for communication with one or more electrical consumers in order to form a battery system.

For meeting the dynamic power demands of various electrical consumers connected to the battery system a static control of battery power output and charging is not sufficient. Thus, steady exchange of information between the battery system and the controllers of the electrical consumers is required. These information includes the battery systems actual state of charge (SoC), potential electrical performance, charging ability and internal resistance as well as actual or predicted power demands or surpluses of the consumers.

In many cases, individual battery modules comprise a printed circuit board (PCB) as an cell supervision circuit (CSC) in order to measure and analyze said parameters. The PCB may further function to establish a connection to control electronics of the battery system, e.g. to a battery management system (BMS) and/or to an external device, such as a board net of an vehicle or the like. For example, utility model CN203812935 discloses a battery pack comprising a PCB, wherein said battery pack can be connected with an external electrical device.

For high-capacity battery modules, that include a large number of interconnected battery cells, a great amount of wirings is needed inside the PBC for monitoring each battery cell and for connecting the PBC with a BMS and/or an external device, thus wiring complexity is high and the connections are susceptible to breakage. Furthermore, the wiring patterns are usually made of copper (Cu), which is expensive. Finally, each wiring has to be welded individually, so that no automated wiring assembly is possible.

It is thus an object of the present invention to overcome or reduce at least some of the drawbacks of the prior art and to provide a battery system with a connector for connecting the PBC to an external connector or consumer.

### Summary of Invention

One aspect of the present invention is to provide a connector part for connecting a PCB of a battery system with an external electrical component which does not require wiring, so that the costs for copper wiring can be reduced and the stability of the connections can be improved.

According to another aspect of the invention a connector part for connecting a PCB of a battery system with an external electrical component is provided which can be easily assembled to the PCB, thus rendering possible an automation of the assembling process and thereby reducing production time and cost.

According to an aspect of the present invention a battery system is provided which comprises a battery module including a plurality of battery cells, a housing accommodating the battery module, and a printed circuit board (PCB), wherein the PCB comprises a plurality of bent terminal portions located on a second surface of the PCB opposed to a first surface facing the battery module; and a connector part for connecting the PCB with an external electrical component, the connector part comprising a plurality of metal clamps adapted to be connected to the bent terminal portions of the PCB. The PCB may be located on the battery module, e.g. on top of the battery module, and may comprise a plurality of terminals for connecting to each of the plurality of battery cells on the first surface of the PCB. Further preferred, the PCB may comprise a plurality of first and second terminals on the first surface that are connected to respective first and second terminals of the battery cells.

Preferably, the metal clamps are arranged in a row extending along a first direction. Preferably, the metal clamps comprise a first subset of metal clamps having a first position along a second direction perpendicular to the first direction and a second subset of metal clamps having a second position along the second direction different from the first position. Preferably, the difference between the first position and the second position is adapted to the arrangement of bent terminal portions on the PCB, wherein the positioning of the clamps as well as the arrangement of the bent terminal portions satisfies requirements of electric isolation. Preferably, the bent terminal portions and the clamps are spaced among themselves with a distance that exceeds a creeping distance. Although the creeping distance in detail depends on the applied voltage, the distance between the first position and the second position may be from 2 to 20 mm, preferably from 4 to 10 mm.

The metal clamps may be made of an electrically conductive materials such as copper or aluminum. The metal clamps may further comprises mixtures of electrically conductive materials. The bent terminal portions may be made of a steel sheet having an "L" shape.

Preferably, the connector part further comprises a clamp carrier for carrying the metal clamps and extending in the first direction, the clamp carrier being located inside the housing, a sealing plate arranged perpendicular to the clamp carrier, and a connector head extending from a surface of the sealing plate opposed to the surface from which the clamp carrier extends, wherein the connector head is arranged outside the housing.

The housing may have an opening for introducing the clamp carrier inside the housing. Preferably, the sealing plate is configured to extend parallel to the side wall of the housing and to cover the opening when the clamp carrier is inserted inside the housing.

Preferably, the clamp carrier, the sealing plate and the connector head are made of molded plastic material. The clamp carrier, the sealing plate and the connector head may be made of a reinforced plastic material such as a fiber-reinforced or particle-reinforced plastic material. Particularly preferred, the aforementioned components may comprise polybutylene terephthalate filled with fibers such as glass fibers.

Preferably, the connector head comprises a plurality of metal pins, each of the metal pins being electrically connected to a corresponding one of the metal clamps. Preferably, the metal pins are arranged along two parallel rows.

Preferably, the metal clamps have a "U" form comprising a main body and two arms extending from the main body. The arms of the metal clamps may be bent towards each other so to form an angle with respect to the second direction so that a gap between the tips of the two arms is formed which is smaller than a distance between the two arms in the vicinity of the main body.

Preferably, the bent terminal portions comprise a flat part extending parallel to the surface of the PCB and being fixed to the PCB, and a protruding part extending perpendicular to the flat part. Preferably, a thickness of the protruding part is greater than the gap between the two arms of the metal clamp.

The tips of the arms may have a profile comprising a curved portion and a straight portion, and a portion of the main body between the two arms may have a concave form.

According to another aspect of the invention a vehicle is provided which includes a battery system with a connector part as described above. The connector part may be connected to an electronic component of the vehicle, such as a battery management system (BSM) or the like and/or to an electric board net of the vehicle. Particularly preferred, the connector part is connected to an 48 V board net of a vehicle via the BMS.

### Brief Description of the Drawings

Features will become apparent to those of ordinary skill in the art by describing in detail exemplary embodiments with reference to the attached drawings in which:
- Fig. 1: illustrates a schematic perspective view of a battery module comprising a plurality of battery cells;
- Fig. 2: illustrates a cross sectional view of a battery system comprising the battery module of Fig. 1 and a connector part according to an embodiment of the present invention;
- Fig. 3: illustrates a perspective view of the connector part according to an embodiment of the invention;
- Fig. 4: illustrates a top view of the battery system of Fig. 2 with the connector part;
- Fig. 5: illustrates an enlarged perspective view of a detail of Fig. 4 showing the metal clamps engaged with the bent terminal portions;
- Fig. 6(a): illustrates a schematic view of the structure of a metal clamp according to an embodiment of the invention; and
- Fig. 6(b): illustrates an enlarged view of area A of Fig. 6(a).

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the drawings, the sizes of elements may be exaggerated for clarity. For example, in the drawings, the size or thickness of each element may be arbitrarily shown for illustrative purposes, and thus the embodiments of the present invention should not be construed as being limited thereto.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention as defined in the appended claims.

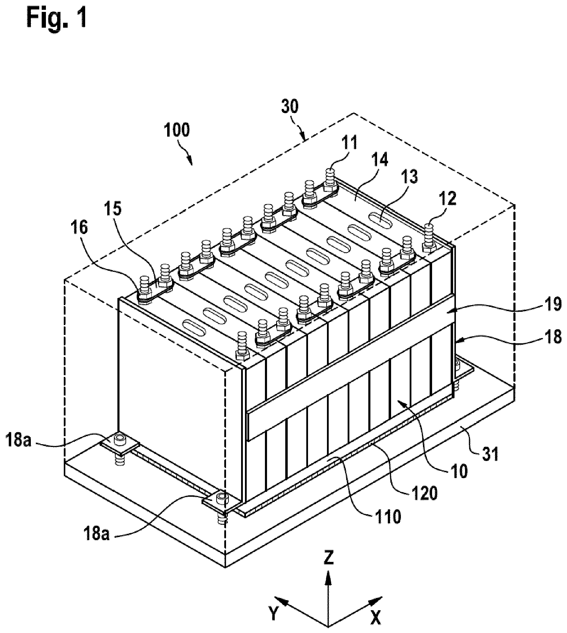

Fig. 1 is a schematic perspective view illustrating a conventional battery module 100. Referring to Fig. 1, the battery module 100 includes a plurality of battery cells 10 aligned in one direction and a pair of end plates 18 provided to face wide surfaces of the battery cells 10 at the outside of the battery cells 10, and a connection plate 19 for connecting the pair of end plates 18 to each other thereby fixing the plurality of battery cells 10 together. Fastening portions 18a on both sides of the battery module 100 are fastened to a support plate 31 by bolts. The support plate 31 is part of a housing 30 enclosing the plurality of battery cells 10.

Here, each battery cell 10 is a prismatic (or rectangular) cell, the wide flat surfaces of the cells being stacked together to form the battery module. Further, each battery cell 10 includes a battery case configured for accommodation of an electrode assembly and an electrolyte. The battery case is hermetically sealed by a cap assembly 14. The cap assembly 14 is provided with positive and negative electrode terminals 11 and 12 having different polarities, and a vent 13. The vent 13 is a safety means of the battery cell 10, which acts as a passage through which gas generated in the battery cell 10 is exhausted to the outside of the battery cell 10. The positive and negative electrode terminals 11 and 12 of neighboring battery cells 10 may be electrically connected through a bus bar 15, and the bus bar 15 may be fixed by a nut 16 or the like.

Generally, the battery cells 10 generate a large amount of heat while being charged/discharged. The generated heat is accumulated in the battery cells 10, thereby accelerating the deterioration of the battery cells 10. Therefore, the battery module 100 may further include a heat exchange member 110, which is provided adjacent to the bottom surface of the battery cells 10 so as to cool down the battery cells 10. In addition, an elastic member 120 made of rubber or other elastic materials may be interposed between the support plate 31 and the heat exchange member 110.

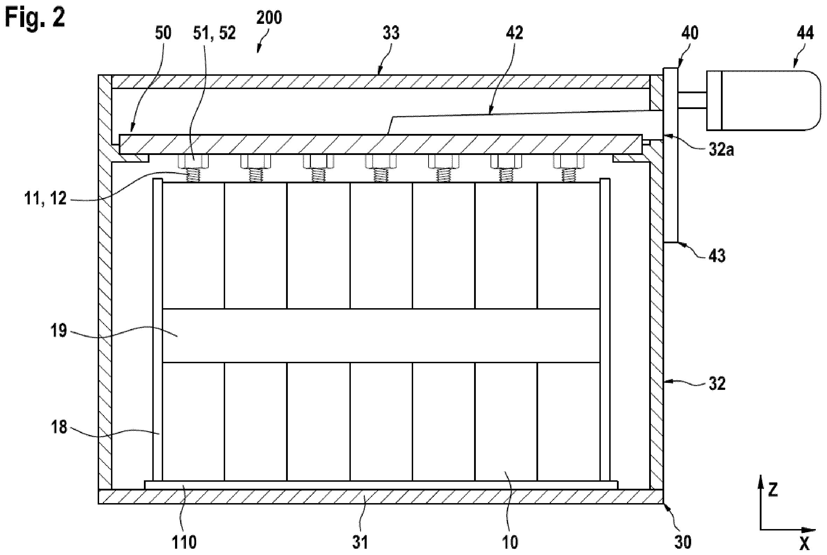

Fig. 2 shows a cross sectional view of a battery system 200 according to an embodiment of the present invention. The battery system 200 comprises a battery module 100, a housing 30 enclosing the battery module 100, a printed circuit board (PBC) 50 located on the battery module 100 and a connector part 40 coupled to the PBC 50.

The battery module 100 corresponds to the battery module 100 shown in Fig. 2, so that a detailed description thereof will be omitted.

The battery module 100 is enclosed by a housing 30 accommodating the battery module 100. The housing 30 comprises a support plate 31 located at a bottom surface of the battery module 100, side walls 32 extending along a periphery of the support plate 31 and surrounding the battery module 31. The housing 30 may further comprise an upper plate 33 connected to the side walls 32 to enclose the accommodating space for the battery module 100 inside the housing 30. Fig. 2 shows an exemplarily embodiment of the invention, wherein the PCB 50 is located inside the housing 30 between the battery module 100 and the upper plate 33 of the housing 30. In any case, the PBC may also be a flexible PCB. However, the present invention is not limited thereto.

Alternately, the PCB 50 provided on the battery module 100 may be connected to the side walls 32 to seal the housing 30. In this case, the PCB 50 may be a rigid printed circuit board that also functions as an upper plate of the housing 30 and has a protective function for the battery module 100. In this case, a main body of the PCB 50 may be formed of a rigid electrically insulating material like polyimide (PI) or polyethylene (PET). According to an embodiment of the present invention the housing 30 may have a rectangular box shape, but the invention should not be construed as being limited thereto.

The printed circuit board (PCB) 50 comprises a plurality of connection terminals 51, 52, e.g. on a lower surface of the PCB 50 facing the battery module 100, for connecting the PCB 50 to each of the battery cells 10. The PCB 50 further comprises a semiconductor device 54 formed on an upper surface of the printed circuit board 50. The semiconductor device 54 may comprise an integrated circuit (IC) that is adapted to measure and analyze relevant parameters, which may include one or more of state of charge (SoC), potential electrical performance, temperature, charging ability and internal resistance of the battery cells 10, and also other parameters according to the requirements. Particularly preferred, the PCB 50 is configured to be connected to each of the battery cells 10 for determining a voltage of each of the battery cells 10 using the semiconductor device 54. The semiconductor device 54 may also apply signals for controlling operations of the battery cells 10. In particular, the semiconductor device 54 may control charging or discharging extents through high current lines of the battery cells 10. In addition, the semiconductor device 54 may generate signals indicating voltages, current and temperatures of the battery cells 10 to prevent for example over-charge or over-discharge.

To this end, the semiconductor device 54 may transmit information about the battery cells 10 to an external electronic device via the connector part 40, wherein the external electronic device may be, for instance, an electronic part of a vehicle or other equipment including the battery system 200. Here, the information about the voltages, currents, SOC and temperatures of the battery cells 10 may be transferred to the connector part 40 via a plurality of bent terminal portions 53 formed on an upper surface of the PCB 50 opposite to the surface facing the battery module 100 and connected to the semiconductor device 54. The bent terminal portions 53 are made of a metal sheet bent in an "L" form and comprise a flat part 53a extending parallel to the surface of the PCB 50 and a protruding part 53b extending perpendicular to the flat part 53a. The flat part 53a is fixed to the surface of the PCB 50, e.g. by soldering. The protruding part 53b has a height (extending in the z direction) ranging from 4 mm to 10 mm and a length (extending in the y direction) ranging from 4 mm to 10 mm. Further, the bent terminal portions 53 may have a thickness between 4 mm and 10 mm.

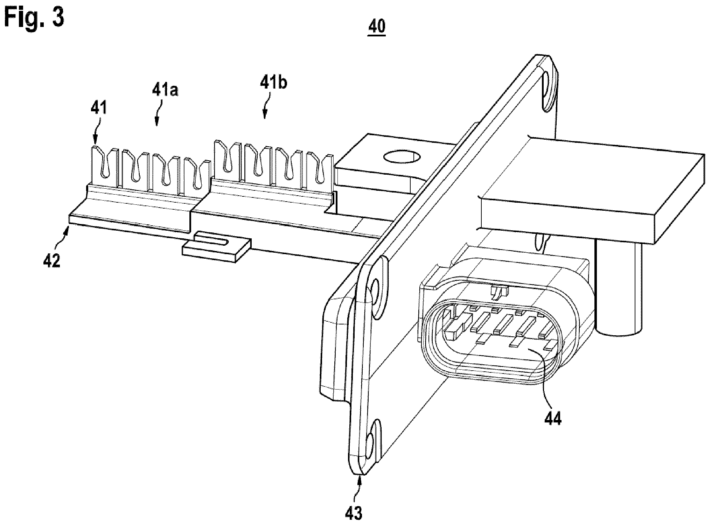

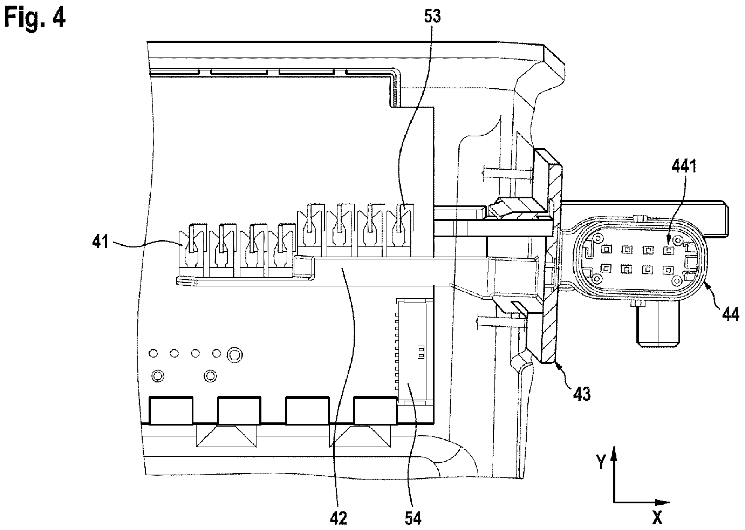

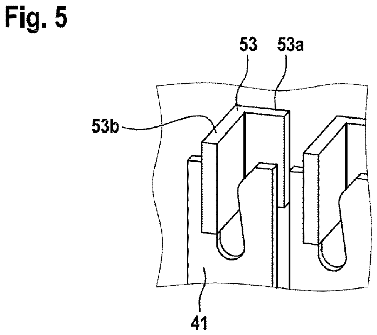

Fig. 3 shows a perspective view of the connector part 40 according to an embodiment of the invention, Fig. 4 shows a top view of the battery system 200 of Fig. 2 with the connector part 40 of Fig. 3, and Fig. 5 shows an enlarged perspective view of metal clamps 41 engaged with the bent terminal portions 53.

Referring to Figs. 3 and 4, the connection part 40 comprises a plurality of metal clamps 41, a clamp carrier 42, a sealing plate 43 and a connector head 44. The metal clamps are designed to be connected to the bent terminal portions 53 of the PCB 50 for transmitting signals from the PCB 50 to a connector head 44 and from the connector head 44 to the PCB 50, wherein the connector head 44 is adapted to be connected to an external electronic device (not shown).

The metal clamps 41 are arranged in a row extending along a first direction (x). The metal clamps 41 are made of a metal sheet and have an approximately rectangular shape with a width parallel to the first direction and a height Hc extending along a second direction (y) perpendicular to the first direction. The metal clamps 41 include two subsets 41a, 41b of metal clamps 41, wherein the first and second subsets 41a, 41b have different positions along the second direction (y). That is, the first and second subsets 41a, 41b are shifted with respect to each other along the second direction..Thus collision of the stamping grids can be avoided. The metal clamps are made to correspond to the bent terminal portions 53 of the PCB 50.

The clamp carrier 42 is a rod extending along the first direction and carrying the metal clamps 41. The sealing plate 43 is a flat part extending in a plane perpendicular to the first direction. The clamp carrier 42 extends from a first surface of the sealing plate 43 which is facing the battery module 100. The connector head 44 extends from a second surface of the sealing plate 43 which is facing away from the battery module 100. The clamp carrier 42, the sealing plate 43 and the connector head 44 may be integrally formed with molded plastic material, such as polybutylene terephthalate filled with fibers such as glass fibers.

In a preferred embodiment, the frame geometry of the connector part is made up of two elements which are over-molded together, wherein the first element comprises the connector head 44 and the pins 441 and the second element comprises the clamp carrier 42 at the other end of the sealing part 43. Further elements may be also part of the connector 40, for example metal bolts for conducting high currents.

The connector head 44 comprises a plurality of metal pins 441, wherein each of the metal pins 441 is electrically connected to a corresponding metal clamp 41. The metal pins 441 are arranged in accordance with the positions of the bent terminal portions 53 on the PCB 50. In principal, the metal pins 441 may be arranged in any given position, according to specific connector requirements. In the illustrated embodiment, the metal pins 441 are arranged along two rows. The electrical connection between the metal clamps 41 and the metal pins 441 is realized with stamping grids embedded in the connector part 40. The connector head 44 is substantially an electrical socket which can be plugged to an external electrical device.

Referring to Fig. 4, the connector part 40 can be easily coupled to the PBC 50 because of the clamping geometry of the metal clamps 41, which will be described in detail later. The bent terminal portions 53 of the PCB 50 are arranged on a surface of the PCB 50 facing away from the battery module 100. The bent terminal portions 53 may be soldered to the surface of the PCB 50. To realize the connection between the PCB 50 and the connector part 40, first of all the clamp carrier 42 is inserted inside the housing 30 in a horizontal direction through an opening 32a provided in one of the side walls 32. The connector part 40 is then fixed to the side walls 32 of the housing 30, for instance by screwing the sealing plate 43 to the side walls 32. The connector part 40 may be hot stamped to the PCB brackets (not shown) which are configured for receiving the PCB. However other fixing methods, e.g. gluing or injection molding, may be employed as well..

After the connector part 40 has been fixed to the housing 30 and the PCB brackets, the PCB 50 is inserted in the housing 30 along a vertical direction (z direction in Fig. 2) and the bent terminal portions 53 are clamped within the metal clamps 41. In this way, the electrical connection between PCB 50 and connector part 40 can be easily realized. In fact, since PCB 50 and connector part 40 can be mounted with simple linear positioning, the assembling process can be automated, thereby reducing production time. Furthermore, since no wirings between the PCB 50 and the connector part 40 are required, the reliability of the connection is improved.

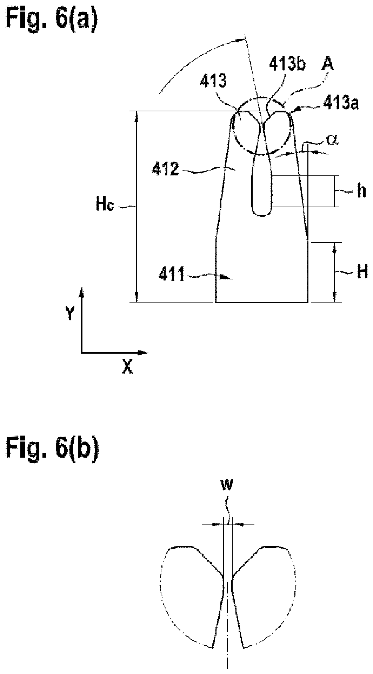

Fig. 6(a) shows a schematic view of the structure of a metal clamp 41 according to an embodiment of the invention and Fig. 6(b) shows an enlarged view of area A Fig. 6(a).

The metal clamps 41 are made of a metal sheet, so that they are substantially flat in a plane parallel to the upper surface of the PCB 50. The metal clamps 41 may be made of a conductive material with elastic properties, e.g. aluminum or copper. Depending on the application, the metal clamps may be also made of lead.

The metal clamps have approximately a "U" form with a main body 411 attached to the clamp carrier 42 and two arms 412 extending from the main body 411 along the second direction (y). The width of the main body may range between 5 and 10 mm and the height H1 of the main body 411 may range between 4 and 8 mm. The height H2 of the arms 412 may range between 4 and 10 mm and the overall height Hc may range between 15 and 22mm.

The arms 412 are bent towards each other so to form an angle (α) with respect to the second direction (y). Thereby, a gap W formed between the tips 413 of the two arms 412 which extend away from the main body 411 is smaller than a distance between the two arms 412 in the vicinity of the main body 411. The gap (W) may range between 0.2 and 0.6mm. The thickness of the metal clamps 41 may range between 0.5 and 1.5 mm, preferably between 0.3 and 1.0mm.

Because the metal clamps are made of a material with elastic properties, the two arms 412 may move away from each other when a pressure is applied in an inner side of the tips 413, thus enlarging the gap and permitting the insertion of the bent terminal portion 53 through the gap.

The thickness of the bent terminal portions 53 of the PCB 50 is chosen to be larger than the gap (W) between the tips 413, so that when the arms 412 move back in their original position the bent terminal portion 53 is stably clamped between the two arms 412 of the metal clamp 41.

According to a preferred embodiment, the tips 413 of the arms 412 have a profile comprising a curved portion 413a and a straight portion 413b. A portion of the main body 411 between the two arms 412 may have a concave form. The profile shown in Figs. 6(a) and 6(b) allows a smooth and stable clamping between the bent terminal portion 53 of the PBC 50 and the metal clamps 41 of the connector part 40. Furthermore, because of the described design of both the metal clamp 41 and the bent terminal portion 53 of the PCB 50, the connection between the two parts can be established with a tolerance in the vertical direction up to 2mm. Hence, the assembly of the connector part is simplified and the stability of the connection is improved.

**Reference signs**

| | | | |
|---|---|---|---|
| 10 | secondary battery cell | 53 | bent terminal portions |
| 11 | first terminal of the battery cell | 53a | flat part |
| 12 | second terminal of the battery cell | 53b | protruding part |
| 14 | cap assembly | 54 | semiconductor device |
| 15 | bus bar | 100 | battery submodule |
| 16 | nut | 110 | heat exchange member |
| 18 | end plate | 120 | elastic member |
| 18a | fastening portion | 200 | battery system |
| 19 | connection plate | | |
| 30 | housing | | |
| 31 | bottom plate | | |
| 32 | side walls | | |
| 32a | opening | | |
| 33 | upper plate | | |
| 40 | connector part | | |
| 41 | metal clamp | | |
| 41a | first subset | | |
| 41b | second subset | | |
| 411 | main body | | |
| 412 | arm | | |
| 413 | tip | | |
| 413a | curved portion of the tip | | |
| 413b | straight portion of the tip | | |
| 42 | clamp carrier | | |
| 43 | sealing plate | | |
| 44 | connector head | | |
| 441 | pins | | |
| 50 | printed circuit board (PCB) | | |
| 51 | first terminal of the PCB | | |
| 52 | second terminal of the PCB | | |

## Claims

1. A battery system (200) comprising:
a battery module (100) including a plurality of secondary battery cells (10);
a housing (30) accommodating the battery module (100);
a printed circuit board PCB (50) located on the battery module (100) and having a first surface facing the battery module (100) and a second surface opposed to the first surface, the PCB (50) comprising a plurality of bent terminal portions (53) located on the second surface of the PCB (50); and
**characterized by**
a connector part (40) for connecting the PCB (50) with an external electrical component, the connector part (40) comprising a plurality of metal clamps (41) designed to be connected to the bent terminal portions (53) of the PCB (50).

2. The battery system of claim 1,
wherein the metal clamps (41) are arranged in a row extending along a first direction (x).

3. The battery system of claim 2,
wherein the metal clamps (41) comprise a first subset (41a) having a first position along a second direction (y) perpendicular to the first direction (x) and a second subset (41b) having a second position along the second direction (y), wherein the first position is different from the second position.

4. The battery system of one of the preceding claims,
wherein the metal clamps (41) are made of an electrically conductive material.

5. The battery system of one of the preceding claims,
wherein the bent terminal portions (53) are made of a steel sheet having an "L" shape.

6. The battery system of one of the claims 2 to 5, wherein the connector part (40) further comprises:
a clamp carrier (42) for carrying the metal clamps (41), the clamp carrier (42) extending in the first direction (x) and being located inside the housing (30);
a sealing plate (43) arranged perpendicular to the clamp carrier (42); and
a connector head (44) extending from a surface of the sealing plate (43) opposed to the surface from which the clamp carrier (42) extends, wherein the connector head (44) is arranged outside the housing (30).

7. The battery system of claim 6,
wherein the housing (30) has an opening (32a) for introducing the clamp carrier (42) inside the housing (30), and
wherein the sealing plate (43) is configured to cover the opening (32a).

8. The battery system of one of claims 6 and 7,
wherein the clamp carrier (42), the sealing plate (43) and the connector head (44) are made of molded plastic material.

9. The battery system of one of claims 6 to 8,
wherein the connector head (44) comprises a plurality of metal pins (441), each of the metal pins (441) being electrically connected to a corresponding one of the metal clamps (41).

10. The battery system of one of the claims 2 to 9,
wherein the metal clamps (41) have a "U" form comprising a main body (411) and two arms (412) extending from the main body (411) along a second direction (y) perpendicular to the first direction (x).

11. The battery system of claim 10,
wherein the arms (412) of the metal clamps (41) are bent towards each other so to form an angle (α) with respect to the second direction (y), and
wherein a gap (W) between the tips (413) of the two arms (412) is smaller than a distance between the two arms (412) in proximity of the main body (411).

12. The battery system of claim 11,
wherein the bent terminal portions (53) of the PCB (50) comprise a flat portion (53a) extending parallel to the surface of the PCB (50) and being fixed to the PCB (50), and a protruding part (53b) extending perpendicular to the flat part (53a) and wherein a thickness of protruding part (53b) is greater than the gap (W) between the two arms (412) of the metal clamp (41).

13. The battery system of one of the preceding claims,
wherein the PCB (50) further comprises a plurality of terminals (51, 52) for electrically connecting the PCB (50) to each of the battery cells (10), and
wherein each of the battery cells (10) is connected to one of the plurality of terminals (51, 52) of the PCB (50), so that the PCB (50) is configured for detecting a voltage of each of the plurality of battery cells (10).

14. A vehicle including a battery system according to one of the preceding claims.

15. The vehicle of claim 14, wherein the connector head (44) of the connector part (40) is electrically connected to an electric board net of the vehicle.

## Patentansprüche

1. Batteriesystem (200), umfassend:
ein Batteriemodul (100), das eine Vielzahl von sekundären Batteriezellen (10) umfasst;
ein Gehäuse (30), welches das Batteriemodul (100) aufnimmt;
eine Leiterplatte, PCB, (50), die sich auf dem Batteriemodul (100) befindet und eine erste Oberfläche, die dem Batteriemodul (100) zugewandt ist, und eine zweite Oberfläche, die der ersten Oberfläche gegenüberliegt, aufweist, wobei die PCB (50) eine Vielzahl von gebogenen Klemmenabschnitten (53) umfasst, die sich auf der zweiten Oberfläche der PCB (50) befinden; und
**gekennzeichnet durch**:
ein Steckerteil (40), um die PCB (50) mit einer externen elektrischen Komponente zu verbinden, wobei das Steckerteil (40) eine Vielzahl von Metallklammern (41) umfasst, die ausgelegt sind, um mit den gebogenen Klemmenabschnitten (53) der PCB (50) verbunden zu werden.

2. Batteriesystem nach Anspruch 1, wobei die Metallklammern (41) in einer Reihe angeordnet sind, die sich in einer ersten Richtung (x) erstreckt.

3. Batteriesystem nach Anspruch 2, wobei die Metallklammern (41) eine erste Teilmenge (41a), die eine erste Position in einer zweiten Richtung (y), die zu der ersten Richtung (x) senkrecht steht, aufweist, und eine zweite Teilmenge (41b), die eine zweite Position in der zweiten Richtung (y) aufweist, umfassen, wobei die erste Position anders als die zweite Position ist.

4. Batteriesystem nach einem der vorhergehenden Ansprüche, wobei die Metallklammern (41) aus einem elektrisch leitenden Material bestehen.

5. Batteriesystem nach einem der vorhergehenden Ansprüche, wobei die gebogenen Klemmenabschnitte (53) aus einem Blech bestehen, das eine L-Form aufweist.

6. Batteriesystem nach einem der Ansprüche 2 bis 5, wobei das Steckerteil (40) ferner Folgendes umfasst:
einen Klammerträger (42) zum Tragen der Metallklammern (41), wobei sich der Klammerträger (42) in der ersten Richtung (x) erstreckt und sich im Innern des Gehäuses (30) befindet;
eine Dichtungsplatte (43), die senkrecht zu dem Klammerträger (42) angeordnet ist; und
einen Anschlusskopf (44), der sich von einer Oberfläche der Dichtungsplatte (43) aus erstreckt, die der Oberfläche gegenüberliegt, von der aus sich der Klammerträger (42) erstreckt, wobei der Anschlusskopf (44) außerhalb des Gehäuses (30) angeordnet ist.

7. Batteriesystem nach Anspruch 6,
wobei das Gehäuse (30) eine Öffnung (32a) zum Einführen des Klammerträgers (42) in das Innere des Gehäuses (30) aufweist, und
wobei die Dichtungsplatte (43) konfiguriert ist, um die Öffnung (32a) abzudecken.

8. Batteriesystem nach einem der Ansprüche 6 und 7, wobei der Klammerträger (42), die Dichtungsplatte (43) und der Anschlusskopf (44) aus einem geformten Kunststoffmaterial besteht.

9. Batteriesystem nach einem der Ansprüche 6 bis 8, wobei der Anschlusskopf (44) eine Vielzahl von Metallstiften (441) umfasst, wobei jeder der Metallstifte (441) mit einer entsprechenden der Metallklammern (41) elektrisch verbunden ist.

10. Batteriesystem nach einem der Ansprüche 2 bis 9, wobei die Metallklammern (41) eine U-Form aufweisen, die einen Hauptkörper (411) und zwei Arme (412), die sich von dem Hauptkörper (411) aus in einer zweiten Richtung (y) erstrecken, die zu der ersten Richtung (x) senkrecht steht, umfasst.

11. Batteriesystem nach Anspruch 10,
wobei die Arme (412) der Metallklammern (41) aufeinander zu gebogen sind, um einen Winkel (α) im Verhältnis zu der zweiten Richtung (y) zu bilden, und wobei eine Lücke (W) zwischen den Spitzen (413) der beiden Arme (412) kleiner als ein Abstand zwischen den beiden Armen (412) in der Nähe des Hauptkörpers (411) ist.

12. Batteriesystem nach Anspruch 11, wobei die gebogenen Klemmenabschnitte (53) der PCB (50) einen flachen Abschnitt (53a), der sich parallel zu der Oberfläche der PCB (50) erstreckt und an der PCB (50) befestigt ist, und einen vorstehenden Teil (53b), der sich senkrecht zu dem flachen Teil (53a) erstreckt, umfassen, und wobei eine Dicke des vorstehenden Teils (53b) größer als die Lücke (W) zwischen den beiden Armen (412) der Metallklammer (41) ist.

13. Batteriesystem nach einem der vorhergehenden Ansprüche,
wobei die PCB (50) ferner eine Vielzahl von Klemmen (51, 52) umfasst, um die PCB (50) mit jeder der Batteriezellen (10) elektrisch zu verbinden, und wobei jede der Batteriezellen (10) mit einer der Vielzahl von Klemmen (51, 52) der PCB (50) verbunden ist, so dass die PCB (50) konfiguriert ist, um eine Spannung jeder der Vielzahl von Batteriezellen (10) zu detektieren.

14. Fahrzeug, umfassend ein Batteriesystem nach einem der vorhergehenden Ansprüche.

15. Fahrzeug nach Anspruch 14, wobei der Anschlusskopf (44) des Steckerteils (40) mit einem elektrischen Bordnetz des Fahrzeugs elektrisch verbunden ist.

## Revendications

1. Système de batterie (200) comprenant :
un module de batterie (100) comprenant une pluralité d'éléments de batterie secondaires (10) ;
un boîtier (30) logeant le module de batterie (100) ;
une carte de circuit imprimé PCB (50) positionnée sur le module de batterie (100) et ayant une première surface faisant face au module de batterie (100) et une seconde surface opposée à la première surface, la PCB (50) comprenant une pluralité de parties de borne pliées (53) positionnées sur la seconde surface de la PCB (50) ; et
**caractérisé par** :
une partie de connecteur (40) pour raccorder la PCB (50) avec un composant électrique externe, la partie de connecteur (40) comprenant une pluralité de pinces métalliques (41) conçues pour être raccordées aux parties de bornes pliées (53) de la PCB (50).

2. Système de batterie selon la revendication 1,
dans lequel les pinces métalliques (41) sont agencées dans une rangée s'étendant le long d'une première direction (x).

3. Système de batterie selon la revendication 2,
dans lequel les pinces métalliques (41) comprennent un premier sous-ensemble (41a) ayant une première position le long d'une seconde direction (y) perpendiculaire à la première direction (x) et un second sous-ensemble (41b) ayant une seconde position le long de la seconde direction (y), dans lequel la première position est différente de la seconde position.

4. Système de batterie selon l'une des revendications précédentes,
dans lequel les pinces métalliques (41) sont réalisées à partir d'un matériau électriquement conducteur.

5. Système de batterie selon l'une des revendications précédentes,
dans lequel les parties de bornes pliées (53) sont réalisées avec une tôle d'acier ayant une forme de « L ».

6. Système de batterie selon l'une des revendications 2 à 5, dans lequel la partie de connecteur (40) comprend en outre :
un support de pince (42) pour porter les pinces métalliques (41), le support de pince (42) s'étendant dans la première direction (x) et étant positionné à l'intérieur du boîtier (30) ;
une plaque d'étanchéité (43) agencée perpendiculairement au support de pince (42) ; et
une tête de connecteur (44) s'étendant à partir d'une surface de la plaque d'étanchéité (43) opposée à la surface à partir de laquelle le support de pince (42) s'étend, la tête de connecteur (44) étant agencée à l'extérieur du boîtier (30).

7. Système de batterie selon la revendication 6,
dans lequel le boîtier (30) a une ouverture (32a) pour introduire le support de pince (42) à l'intérieur du boîtier (30), et
dans lequel la plaque d'étanchéité (43) est configurée pour recouvrir l'ouverture (32a).

8. Système de batterie selon l'une des revendications 6 et 7,
dans lequel le support de pince (42), la plaque d'étanchéité (43) et la tête de connecteur (44) sont réalisés avec une matière plastique moulée.

9. Système de batterie selon l'une des revendications 6 à 8,
dans lequel la tête de connecteur (44) comprend une pluralité de broches métalliques (441), chacune des broches métalliques (441) étant électriquement raccordée à une pince correspondante des pinces métalliques (41).

10. Système de batterie selon l'une des revendications 2 à 9,
dans lequel les pinces métalliques (41) ont une forme de « U » comprenant un corps principal (411) et deux bras (412) s'étendant à partir du corps principal (411) le long d'une seconde direction (y) perpendiculaire à la première direction (x).

11. Système de batterie selon la revendication 10,
dans lequel les bras (412) des pinces métalliques (41) sont pliés l'un vers l'autre afin de former un angle (α) par rapport à la seconde direction (y), et
dans lequel un espace (W) entre les pointes (413) des deux bras (412) est inférieur à une distance entre les deux bras (412) à proximité du corps principal (411).

12. Système de batterie selon la revendication 11,
dans lequel les parties de bornes pliées (53) de la PCB (50) comprennent une partie plate (53a) s'étendant parallèlement à la surface de la PCB (50) et étant fixées à la PCB (50), et une partie en saillie (53b) s'étendant perpendiculairement à la partie plate (53a) et dans lequel une épaisseur de la partie en saillie (53b) est supérieure à l'espace (W) entre les deux bras (412) de la pince métallique (41).

13. Système de batterie selon l'une des revendications précédentes,
dans lequel la PCB (50) comprend en outre une pluralité de bornes (51, 52) pour raccorder électriquement la PCB (50) à chacun des éléments de batterie (10), et
dans lequel chacun des éléments de batterie (10) est raccordé à l'une de la pluralité de bornes (51, 52) de la PCB (50), de sorte que la PCB (50) est configurée pour détecter une tension de chacun de la pluralité d'éléments de batterie (10).

14. Véhicule comprenant un système de batterie selon l'une des revendications précédentes.

15. Véhicule selon la revendication 14, dans lequel la tête de connecteur (44) de la partie de connecteur (40) est électriquement raccordée à un réseau de tableau électrique du véhicule.
